# EUROPEAN PATENT APPLICATION

(11) **EP 2 366 814 A1**
(43) Date of publication of application: **21.09.2011**
(21) Application number: 09828609.9
(22) Date of filing: 06.11.2009
(51) Int. Cl.: C30B 13/20, H05B 6/42

(54) **HIGH-FREQUENCY COIL PULLING HOLES ARRANGEMENT FOR PRODUCING MULTIPLE SILICON CORES**

(30) Priority: 25.11.2008 CN 200810182057; 25.11.2008 CN 200810182000; 25.11.2008 CN 200810182058; 25.11.2008 CN 200810182056; 25.11.2008 CN 200810182054; 25.11.2008 CN 200810181999; 25.11.2008 CN 200810182055; 25.11.2008 CN 200810181998; 25.11.2008 CN 200810182052; 25.11.2008 CN 200810182053; 06.01.2009 CN 200910064014; 06.01.2009 CN 200910064013; 06.01.2009 CN 200910064012; 06.01.2009 CN 200910064016; 06.01.2009 CN 200910064015
(71) Applicant: Liu, Chaoxuan, Luoyang, Henan 471009 (CN)
(72) Inventor: Liu, Chaoxuan, Luoyang, Henan 471009 (CN)
(74) Representative: Maiwald Patentanwalts GmbH
(86) International application number: PCT/CN2009/074838
(87) International publication number: WO 2010/060349

(57) **Abstract**

The invention discloses a high-frequency coil pulling holes arrangement for producing multiple silicon cores in the technical field of high-frequency coil. The running electric current can be made to spread generally uniformly around each said pulling hole by the diversion effect of diffluent trough or diffluent trough and subsidiary electric current guiding holes by means of changing the positions of diffluent trough and assisted by said "C" shape diffluent trough and subsidiary electric current guiding holes, and alternatively by means of providing interconnected diffluent trough between two pulling holes to form barbell-like part between pulling holes at the outer end of radial diffluent troughs. Because the electric current can more uniformly spread around each pulling hole assisted by diffluent trough, it is accomplished that the current is uniformly spread around pulling holes and consequently the appearance of low quality products can be diminished.

## Description

### Field of the Invention

The present invention belongs to the technical field of high-frequency coil, relating to a structure which can simultaneously produce multiple silicon cores or the crystalline materials by leading electric current to be evenly spread around pulling holes and silicon cores or the other crystalline materials to be evenly heated through the electric current, and particularly to a high-frequency coil pulling holes arrangement for producing multiple silicon cores or crystalline materials by leading the electric current to be evenly spread.

### Background of the Invention

It is well known that with the gradual exhaustion of the non-renewable energy resources, the development and the use of the new energy resources such as the solar energy and the like have become a major trend. The polycrystalline silicon is a main material for producing the solar battery, the demand of the polycrystalline silicon of every country in the world is increased year by year, and the silicon core is the necessary raw material for producing the polycrystalline silicon by means of the non-Siemens, so that the use amount of the silicon core is enormous all around the world. The existing technical process for producing the silicon core, the single crystal silicon and the other material crystalloid in a zone-melting way generally uses a monocular high-frequency coil, wherein the working principle is as follows: when working, the high-frequency coil is electrified with high frequency to generate electric current so as to heat up a raw material stick in an induction way, the upper end of the heated raw material stick is formed into a melting region, seed crystal is inserted into the melting region, the seed crystal is slowly lifted up, and the melted material can be lifted up along with the raise of the seed crystal to form into a new column-shaped crystalloid, wherein the new column-shaped crystalloid is the finished products of the silicon core or the other material crystalloid.

The experiments show that the China utility mode patents which are previously applied by the inventor have various problems, wherein the China utility mode patents are as follows:
Patent 1: Patent Name: high-frequency double-mesh coil capable of simultaneouslly producing two silicon cores and other crystal materials; Application Data: 14.04.2006; and Publication Number: CN2926264Y;
Patent 2: Patent Name: high-frequency coil capable of producing two silicon cores or other crystal materials simultaneouslly; Application Data: 19.01.2007; and Publication Number: CN201001211Y;
Patent 3: Patent Name: high-frequency coil capable of simultaneously producing two silica core or other crystal materials; Application Data: 13.02.2007; and Publication Number: CN201024223Y;
Patent 4: Patent Name: high-frequency coil capable of simultaneouslly producing three silicon cores or other crystal materials; Application Data: 19.01.2007; and Publication Number: CN200999270Y;
Patent 5: Patent Name: high-frequency coil capable of producing three silicon cores or other crystal materials simultaneouslly; Application Data: 19.01.2007; and Publication Number: CN201001208Y;
Patent 6: Patent Name: high-frequency coil capable of producing three silica cores or other crystal material simultaneously; Application Data: 13.02.2007; and Publication Number: CN201024224Y;
Patent 7: Patent Name: high-frequency coil capable of producing three silica cores or other crystal material simultaneously; Application Data: 13.02.2007; and Publication Number: CN201024227Y;
Patent 8: Patent Name: high-frequency coil capable of producing four silicon cores or other crystal materials simultaneouslly; Application Data: 19.01.2007; and Publication Number: CN201001209Y;
Patent 9: Patent Name: high-frequency coil capable of producing four silicon cores or other crystal materials simultaneouslly; Application Data: 13.02.2007; and Publication Number: CN201024228Y;
Patent 10: Patent Name: high-frequency coil capable of producing five silicon cores or other crystal materials simultaneouslly; Application Data: 19.01.2007; and Publication Number: CN200996058Y;
Patent 11: Patent Name: high-frequency coil capable of producing five silicon cores or other crystal materials simultaneouslly; Application Data: 13.02.2007; and Publication Number: CN201024229Y;
Patent 12: Patent Name: high-frequency coil capable of producing six silicon cores or other crystal materials simultaneouslly; Application Data: 19.01.2007; and Publication Number: CN200999269Y,
Patent 13: Patent Name: high-frequency coil capable of producing six silicon cores or other crystal materials simultaneouslly; Application Data: 13.02.2007; and Publication Number: CN201024225Y;
Patent 14: Patent Name: high-frequency coil capable of producing seven silicon cores or other crystal materials simultaneouslly; Application Data: 19.01.2007; and Publication Number: CN200996059Y;
Patent 15: Patent Name: high-frequency coil capable of producing seven silicon cores or other crystal materials simultaneouslly; Application Data: 13.02.2007; and Publication Number: CN201024226Y:

As the high-frequency coils disclosed in the patents has no reasonable configuration, the uneven thickness of the seed crystal can be existed if multiple silicon cores are wanted to be produced simultaneously; so that it is impossible for simultaneously producing more than ten seed crystals with the high-frequency coils disclosed in the patents. However, the yield of the seed crystals in one time directly influences the input-output ratio, and the benefit is completely determined by the amount of the finished produces of the pulling silicon cores. The experiments show that the electric current operation of the high-frequency coils around the pulling holes can not achieve a prospective aim, so that the electric current operation is more except the middle polling hole and the polling holes which are connected with the diffluent troughs, and the enclosed circuit of the plurality of peripherally-distributed pulling holes are influenced by the operation principle of high-frequency electric current, so that the temperatures of the most pulling holes are far lower than those of the pulling holes which are near to or connected with the diffluent troughs, i.e. the called short circuit in the field, therefore, the diameters of the raised seed crystals are quite different from each other, thus greatly increasing the amount of low-quality products. The invention is disclosed on the basis of the problems.

### Summary of the Invention

Aiming at effectively overcoming the problems, the invention discloses a high-frequency coil pulling holes arrangement for producing multiple silicon cores. The running electric current can be made to spread generally uniformly around each said pulling hole by the diversion effect of diffluent trough or diffluent trough and subsidiary electric current guiding holes by means of changing the positions of diffluent trough and assisted by said "C" shape diffluent trough and subsidiary electric current guiding holes, and alternatively by means of providing interconnected diffluent trough between two pulling holes to form barbell-like part between pulling holes at the outer end of radial diffluent troughs. Because the electric current can more uniformly spread around each pulling hole assisted by diffluent trough, it is accomplished that the current is uniformly spread around pulling holes and consequently the appearance of low quality products can be diminished.

In order to implement the purposes, the invention has the following technical scheme:

A high-frequency coil pulling holes arrangement for producing multiple silicon cores, wherein one side of a high-frequency coil 1 is provided with a current transmitting and cooling water transmitting cropper pipeA 5 and a current transmitting and cooling water transmitting cropper pipeB 6, which are adjacent to each other; inward-extended diffluent troughs 2 are arranged between the adjacent current transmitting and cooling water transmitting cropper pipeA 5 and the current transmitting and cooling water transmitting cropper pipeB 6; the upper surface 9 of the high-frequency coil 1 is an inclined plane which is inwards sunken to the center position; the lower surface 10 of the high-frequency coil 1 is provided with a middle sunken circular step; a cooling water channel 4 is buried circularly in the outer edge surface of the high-frequency coil 1; and the two ends of the cooling water channel 4 are respectively communicated with the current transmitting and cooling water transmitting cropper pipeA 5 and the current transmitting and cooling water transmitting cropper pipeB 6;
the diffluent troughs 2 are communicated with pulling holes 3 which are arranged at a concave 7 on the middle of the high-frequency coil 1 or the pulling holes 3 with the shortest straight-line distance or any one of the upper end and lower end of the I shaped diffluent trough 2 which is arranged at the middle of the high-frequency coil 1 to correspond to the straight-line diffluent trough 2 which is arranged at the middle part of the I'-shaped diffluent trough 2;
wherein, subsidiary electric current guiding holes 11 are arranged at the two ends of a 'C'-shaped diffluent trough 12; or the subsidiary electric current guiding holes 11 are arranged at the middle of the diffluent troughs 2; or the subsidiary electric current guiding holes 11 are arranged at the outer ends of the diffluent troughs 2; and
the number of the pulling holes 3 are at least to be 2; the two pulling holes 3 are arranged among I'-shaped endpoints corresponding to the two sides of the I'-shaped diffluent trough 2 to form into the two-pulling holes arrangement; or the two pulling holes 3 are arranged up and down in parallel, one pulling hole 3 which is communicated with the diffluent troughs 2 is provided with the 'C'-shaped diffluent trough 12 which packs a half of the other pulling hole 3, and the two ends of the 'C'-shaped diffluent trough 12 are provided with the subsidiary electric current guiding holes 11 to form into the other two-pulling holes arrangement; or three pulling holes 3 are arranged like a Chinese character ' 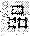 ', wherein one side of one pulling hole 3 is connected with the diffluent troughs 2 between the current transmitting and cooling water transmitting cropper pipeA 5 and the current transmitting and cooling water transmitting cropper pipeB 6, the other side thereof is communicated with the lower end of the 'T'-shaped diffluent trough 2, the two sides of the 'T'-shaped diffluent troughs 2 are respectively provided with the other two pulling holes 3, and the two edges of one pulling hole 3 are respectively provided with a short trough 13 to jointly form into the three-pulling holes arrangement; or the diffluent troughs 2 which are arranged between the current transmitting and cooling water transmitting cropper pipeA 5 and the current transmitting and cooling water transmitting cropper pipeB 6 are communicated with the pulling holes 3 which are arranged at the place which is slightly far away from the middle of the high-frequency coil 1, the other two faces of the pulling holes 3 are provided with the diffluent troughs 2, the outer ends of the two diffluent troughs 2 are respectively provided with the subsidiary electric current guiding holes 11, wherein the other two pulling holes 3 are arranged at the two sides of the diffluent troughs 2 to jointly form into the other three-pulling holes arrangement; or the four pulling holes 3 are arranged by means of square, the diffluent troughs 2 between the current transmitting and cooling water transmitting cropper pipeA 5 and the current transmitting and cooling water transmitting cropper pipeB 6 correspond to and are communicated with two of the pulling holes 3 thereinto, the two sides of the two pulling holes 3 are respectively communicated with the subsidiary electric current guiding holes 11 through the diffluent troughs 2, the middle parts of the communicated diffluent troughs 2 between the two pulling holes 3 are provided with the subsidiary electric current guiding holes 11, and the other two pulling holes 3 are arranged at the two sides of the subsidiary electric current guiding holes 11 to form into four-pulling holes arrangement; or the four pulling holes 3 have the following arrangement: one pulling hole 3 is arranged at the middle, the other three pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the three pulling holes 3 and are communicated with the middle pulling hole 3, the other two diffluent troughs 2 are outwards extended from the middle pulling hole 3 to be positioned between the two pulling holes 3 of the three enclosed pulling holes 3, and the outer ends of the two diffluent troughs 2 are positioned between the circular center lines of the three enclosed pulling holes 3 and the peripheral circular lines of the three enclosed pulling holes 3 to form into the other four-pulling holes arrangement; or one pulling hole 3 is arranged at the middle part, the other pulling holes 3 encloses around the middle pulling hole 3, the diffluent troughs 2 between the current transmitting and cooling water transmitting cropper pipeA 5 and the current transmitting and cooling water transmitting cropper pipeB 6 are communicated with the middle pulling hole 3, the diffluent troughs 2 are respectively arranged among the peripherally-enclosed pulling holes 3, or the middle pulling hole 3 is directly communicated with the peripheral pulling holes 3 through the diffluent troughs 2.

Said high-frequency coil pulling holes arrangement for producing multiple silicon cores, wherein the high-frequency coil pulling holes arrangement for producing five silicon cores is that one pulling hole 3 is arranged at the middle part, the other four pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the four pulling holes 3 and are communicated with the middle pulling hole 3, the other three diffluent troughs 2 are outwards extended from the middle pulling hole 3 to be positioned among the three pulling holes 3 of the four enclosed pulling holes 3, and the outer ends of the three diffluent troughs 2 are positioned between the circular center lines of the four enclosed pulling holes 3 and the peripheral circular lines of the four enclosed pulling holes 3 to form into the five-pulling holes arrangement.

Said high-frequency coil pulling holes arrangement for producing multiple silicon cores, wherein the high-frequency coil pulling holes arrangement for producing six silicon cores is that one pulling hole 3 is arranged at the middle part, the other five pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the five pulling holes 3 and are communicated with the middle pulling hole 3, the other four diffluent troughs 2 are outwards extended from the middle pulling hole 3 to be positioned among the four pulling holes 3 of the five enclosed pulling holes 3, and the outer ends of the four diffluent troughs 2 are positioned between the circular center lines of the five enclosed pulling holes 3 and the peripheral circular lines of the five enclosed pulling holes 3 to form into the six-pulling holes arrangement.

Said high-frequency coil pulling holes arrangement for producing multiple silicon cores, wherein the high-frequency coil pulling holes arrangement for producing seven silicon cores is that one pulling hole 3 is arranged at the middle part, the other six pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the six pulling holes 3 and are communicated with the middle pulling hole 3, the other five diffluent troughs 2 are outwards extended from the middle pulling hole 3 to be positioned among the five pulling holes 3 of the six enclosed pulling holes 3, and the outer ends of the five diffluent troughs 2 are positioned between the circular center lines of the six enclosed pulling holes 3 and the peripheral circular lines of the six enclosed pulling holes 3 to form into the seven-pulling holes arrangement.

Said high-frequency coil pulling holes arrangement for producing multiple silicon cores, wherein the high-frequency coil pulling holes arrangement for producing eight silicon cores is that one pulling hole 3 is arranged at the middle part, the other seven pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the seven pulling holes 3 and are communicated with the middle pulling hole 3, the other six diffluent troughs 2 are outwards extended from the middle pulling hole 3 to be positioned among the six pulling holes 3 of the seven enclosed pulling holes 3, and the outer ends of the six diffluent troughs 2 are positioned between the circular center lines of the seven enclosed pulling holes 3 and the peripheral circular lines of the seven enclosed pulling holes 3 to form into the eight-pulling holes arrangement.

The invention has an extended structure, i.e. the two pulling holes 3 and the diffluent troughs 2 connected therewith are formed into barbell-like pulling holes 3, and the barbell-like pulling holes 3 are respectively arranged between the middle pulling hole 3 and the peripheral pulling holes 3 to form into thirteen, sixteen, nineteen and twenty two high-frequency coil pulling holes arrangement.

Said high-frequency coil pulling holes arrangement for producing multiple silicon cores, wherein the high-frequency coil pulling holes arrangement for producing thirteen silicon cores is that one pulling hole 3 is arranged at the middle part, the other four pulling holes 3 which enclose the middle pulling hole 3 are respectively and equidistantly arranged around the middle pulling hole 3, the diffluent troughs 2 between the current transmitting and cooling water transmitting cropper pipeA 5 and the current transmitting and cooling water transmitting cropper pipeB 6 are communicated with one of the four pulling holes 3 which enclose the middle pulling hole 3, the four enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling hole 3 of the four enclosed pulling holes 3 to form into the thirteen-pulling holes arrangement.

Said high-frequency coil pulling holes arrangement for producing multiple silicon cores, wherein the high-frequency coil pulling holes arrangement for producing sixteen silicon cores is that one pulling hole 3 is arranged at the middle part, the other five pulling holes 3 which enclose the middle pulling hole 3 are respectively and equidistantly arranged around the outer part of the middle pulling hole 3, the diffluent troughs 2 between the current transmitting and cooling water transmitting cropper pipeA 5 and the current transmitting and cooling water transmitting cropper pipeB 6 are communicated with one of the five enclosed pulling holes 3, the five enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling hole 3 of the five enclosed pulling holes 3 to form into the sixteen-pulling holes arrangement.

Said high-frequency coil pulling holes arrangement for producing multiple silicon cores, wherein the high-frequency coil pulling holes arrangement for producing nineteen silicon cores is that one pulling hole 3 is arranged at the middle part, the other six pulling holes 3 which enclose the middle pulling hole 3 are respectively and equidistantly arranged around the outer part of the middle pulling hole 3, the periphery of the six pulling holes 3 which enclose the middle pulling hole 3 are further provided with six pulling holes 3 corresponding thereto, i.e. the outer edge of the middle pulling hole 3 is enclosed by two layers of the pulling holes 3, the diffluent troughs 2 between the current transmitting and cooling water transmitting cropper pipeA 5 and the current transmitting and cooling water transmitting cropper pipeB 6 are communicated with one of the outermost enclosed six pulling holes 3, the outermost enclosed six pulling holes 3 are respectively passed through the middle other six pulling holes 3 and communicated with the middle pulling hole 3 by the diffluent troughs 2 to form into outward serial structures from the middle part, barbell-like pulling structures which are formed by the two pulling holes 3 and the diffluent troughs 2 communicated therewith are respectively arranged among every two serial structures, and independent pulling holes 3 are respectively arranged between the barbell-like pulling structures and the enclosed peripheral six pulling holes 3 to form into the nineteen-pulling holes arrangement.

Said high-frequency coil pulling holes arrangement for producing multiple silicon cores, wherein the high-frequency coil pulling holes arrangement for producing tenwty two silicon cores is that one pulling hole 3 is arranged at the middle part, the other seven pulling holes 3 which enclose the middle pulling hole 3 are respectively and equidistantly arranged around the outer part of the middle pulling hole 3, the diffluent troughs 2 between the current transmitting and cooling water transmitting cropper pipeA 5 and the current transmitting and cooling water transmitting cropper pipeB 6 are communicated with one of the seven enclosed pulling holes 3, the seven enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling hole 3 of the seven enclosed pulling holes 3 to form into the tenwty two-pulling holes arrangement.

Said high-frequency coil pulling holes arrangement for producing multiple silicon cores, wherein the other extended structure for producing nineteen silicon cores is that one pulling hole 3 is arranged at the middle part, the other six pulling holes 3 are arranged at the periphery of the middle pulling hole 3, the diffluent troughs 2 are radially communicated with the six pulling holes 3 through the middle pulling hole 3, and barbell-like pulling structures which are formed by the two pulling holes 3 and the diffluent troughs 2 communicated therewith are respectively arranged among every pulling hole 3 to form into the other nineteen-pulling holes arrangement.

By adopting the technical scheme, the invention has the following advantages:

The high-frequency coil pulling holes arrangement for producing multiple silicon cores of the invention, wherein the diffluent troughs are radially arranged among the pulling holes; or the two sides of pulling holes are provided with 'C'-shaped diffluent troughs and assisted by subsidiary electric current guiding holes; or the two sides of the pulling holes are respectively provided with short grooves; or the communicated diffluent troughs are arranged between every two pulling holes to form into a barbell-like part at the outer end of radial diffluent troughs for pulling 2-8 and 13 or 16 or 19 or 22 silicon cores. Because the running electric current can be made to spread generally uniformly around each said pulling hole by the diversion effect of diffluent trough or diffluent trough and subsidiary electric current guiding holes, and the electric current can more uniformly spread around each pulling hole under the assist of the diffluent troughs, it is accomplished that the current is uniformly spread around the pulling holes, consequently the appearance of low quality products can be diminished, the energy use ratio is improved, and the production cost and the defective percentage are reduced. The invention can evenly heat, saves a great deal of energy, reduces the equipment investment and labor aggregate cost, etc.

### Brief Descriptions of the Drawings

Fig. 1 is a schematic diagram of the structures of the two pulling holes of the present invention;
Fig. 2 is a schematic diagram of the working principle of the electric current running of the two pulling holes of the present invention;
Fig. 3 is a schematic diagram of the structures of the two pulling holes in the other embodiment of the present invention;
Fig. 4 is a schematic diagram of the working principle of the electric current running of the two pulling holes in the other embodiment of the present invention;
Fig. 5 is a schematic diagram of the structures of the three pulling holes of the present invention;
Fig. 6 is a schematic diagram of the working principle of the electric current running of the three pulling holes of the present invention;
Fig. 7 is a schematic diagram of the structures of the three pulling holes in the other embodiment of the present invention;
Fig. 8 is a schematic diagram of the working principle of the electric current running of the three pulling holes in the other embodiment of the present invention;
Fig. 9 is a schematic diagram of the structures of the four pulling holes of the present invention;
Fig. 10 is a schematic diagram of the working principle of the electric current running of the four pulling holes of the present invention;
Fig. 11 is a schematic diagram of the structures of the four pulling holes in the other embodiment of the present invention;
Fig. 12 is a schematic diagram of the working principle of the electric current running of the four pulling holes in the other embodiment of the present invention;
Fig. 13 is a schematic diagram of the structures of the five pulling holes of the present invention;
Fig. 14 is a schematic diagram of the working principle of the electric current running of the five pulling holes of the present invention;
Fig. 15 is a schematic diagram of the structures of the six pulling holes of the present invention;
Fig. 16 is a schematic diagram of the working principle of the electric current running of the six pulling holes of the present invention;
Fig. 17 is a schematic diagram of the structures of the seven pulling holes of the present invention;
Fig. 18 is a schematic diagram of the working principle of the electric current running of the seven pulling holes of the present invention;
Fig. 19 is a schematic diagram of the structures of the eight pulling holes of the present invention;
Fig. 20 is a schematic diagram of the working principle of the electric current running of the eight pulling holes of the present invention;
Fig. 21 is a schematic diagram of the structures of the thirteen pulling holes of the present invention;
Fig. 22 is a schematic diagram of the working principle of the electric current running of the thirteen pulling holes of the present invention;
Fig. 23 is a schematic diagram of the structures of the sixteen pulling holes of the present invention;
Fig. 24 is a schematic diagram of the working principle of the electric current running of the sixteen pulling holes of the present invention;
Fig. 25 is a schematic diagram of the structures of the sixteen pulling holes in the other embodiment of the present invention;
Fig. 26 is a schematic diagram of the working principle of the electric current running of the sixteen pulling holes in the other embodiment of the present invention;
Fig. 27 is a schematic diagram of the structures of the nineteen pulling holes of the present invention;
Fig. 28 is a schematic diagram of the working principle of the electric current running of the nineteen pulling holes of the present invention;
Fig. 29 is a schematic diagram of the structures of the twenty two pulling holes of the present invention;
Fig. 30 is a schematic diagram of the working principle of the electric current running of the twenty two pulling holes of the present invention;
Fig. 31 is a schematic diagram of the distribution of the magnetic force with different intensity of a magnetic force line in pulled seed crystal of the present invention;
Fig. 32 is a three-dimensional schematic diagram of the structures of the eight pulling holes of the prevent invention;
Fig. 33 is a schematic diagram of the structure of the cross section of the high-frequency coil of the prevent invention;

In the figures: 1 high-frequency coil; 2 diffluent trough; 3 pulling hole; 4 cooling water channel; 5 current transmitting and cooling water transmitting cropper pipeA; 6 current transmitting and cooling water transmitting cropper pipeB; 7 concave on coil; 8 electric current; 9 the upper surface of high-frequency coil; 10 the lower surface of high-frequency coil; 11 subsidiary electric current guiding hole; 12 'C'-shaped diffluent trough; 13 short groove; 14 clamp head of seed crystal; 15 seed crystal; 16 raw material stick; and 17 magnetic force line.

### Detailed Descriptions of the Embodiments

Referring to the following embodiments, the invention can be illustrated in more detail but not limited to the embodiments.

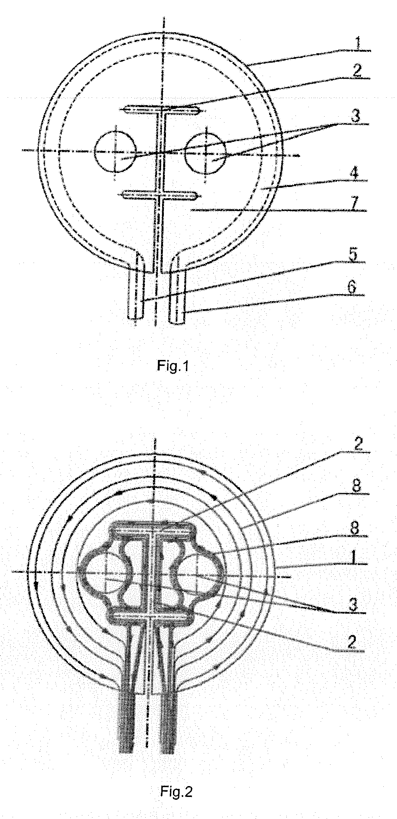

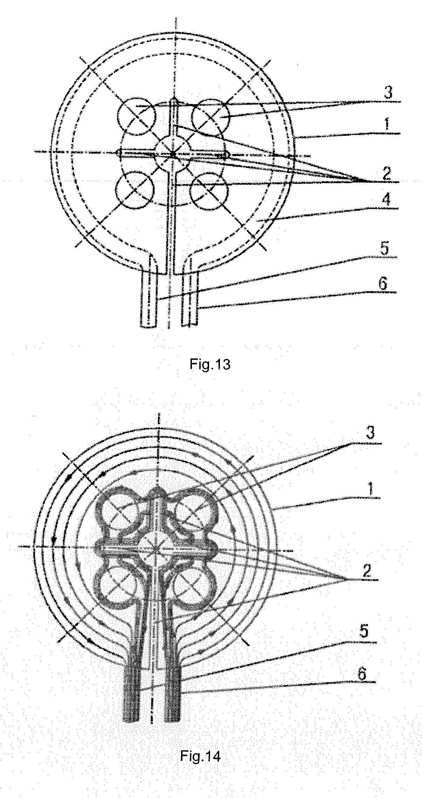

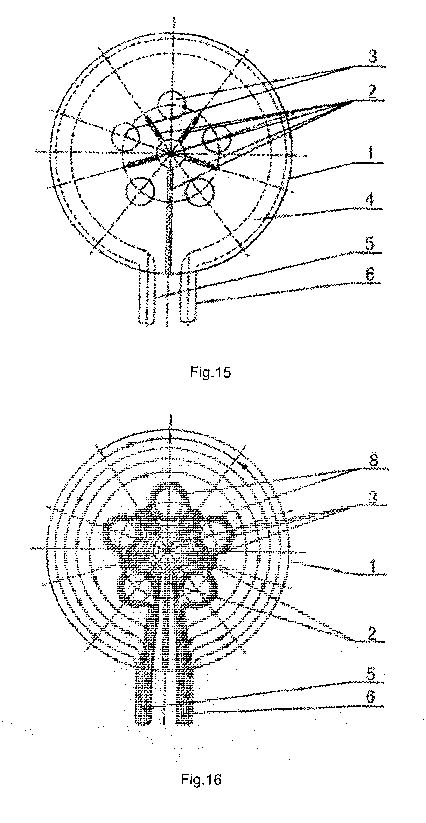

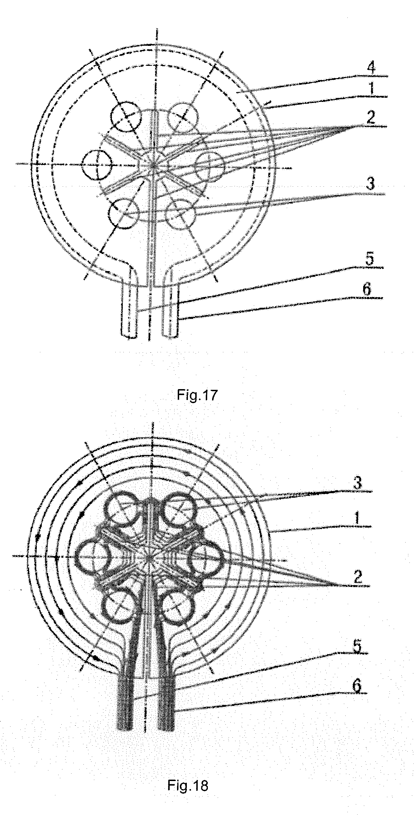

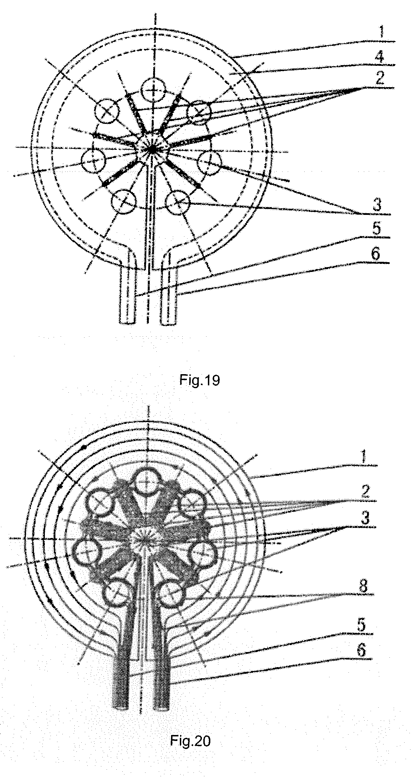

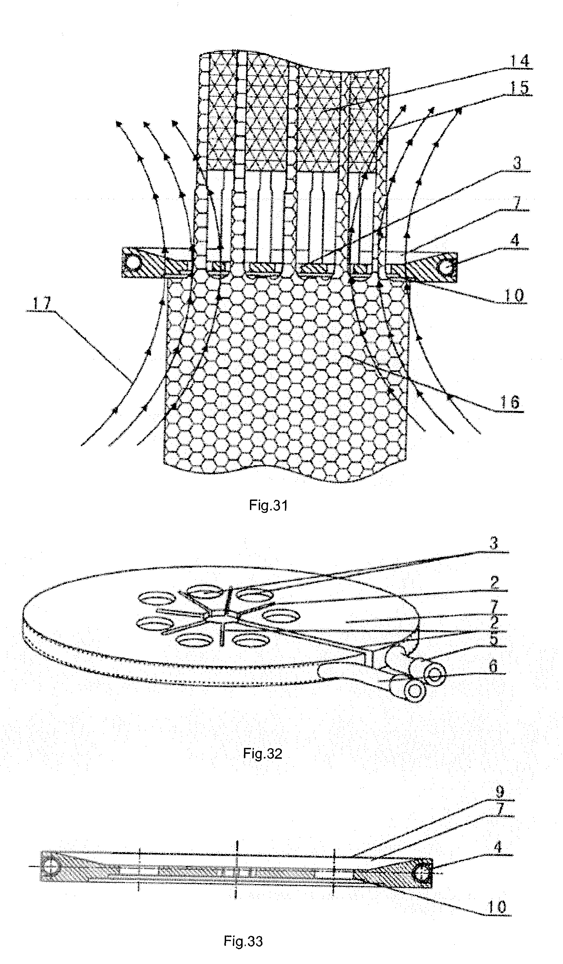

In the embodiment according to the Fig.31, Fig.32 or Fig.33, wherein the Fig.1- Fig.30 are the jointly-used parts of each embodiment, one side of a high-frequency coil 1 is provided with a current transmitting and cooling water transmitting cropper pipeA 5 and a current transmitting and cooling water transmitting cropper pipeB 6, which are adjacent to each other; inward-extended diffluent troughs 2 are arranged between the adjacent current transmitting and cooling water transmitting cropper pipeA 5 and the current transmitting and cooling water transmitting cropper pipeB 6; the upper surface 9 of the high-frequency coil 1 is an inclined plane which is inwards sunken to the center position; the lower surface 10 of the high-frequency coil 1 is provided with a middle sunken circular step; a cooling water channel 4 is buried circularly in the outer edge surface of the high-frequency coil 1; and the two ends of the cooling water channel 4 are respectively communicated with the current transmitting and cooling water transmitting cropper pipeA 5 and the current transmitting and cooling water transmitting cropper pipeB 6;
the diffluent troughs 2 are communicated with pulling holes 3 which are arranged at a concave 7 on the middle of the high-frequency coil 1 or the pulling holes 3 with the shortest straight-line distance or any one of the upper end and lower end of the I`-shaped diffluent trough 2 which is arranged at the middle of the high-frequency coil 1 to correspond to the straight-line diffluent trough 2 which is arranged at the middle part of the I'-shaped diffluent trough 2; and the diffluent troughs 2 are formed into an inside-outside through structure;
wherein, subsidiary electric current guiding holes 11 are arranged at the two ends of a 'C'-shaped diffluent trough 12; or the subsidiary electric current guiding holes 11 are arranged at the middle of the diffluent troughs 2; or the subsidiary electric current guiding holes 11 are arranged at the outer ends of the diffluent troughs 2; and the number of the pulling holes 3 is at least to be 2.

Referring to Fig.1 and Fig.2, the two pulling holes 3 are arranged among I'-shaped endpoints corresponding to the two sides of the I'-shaped diffluent trough 2 to form into the two-pulling holes arrangement; and when working, by running in an encircling way and being guided by the I'-shaped diffluent trough 2, the electric current 8 evenly flows by respectively encircling the two pulling holes 3.

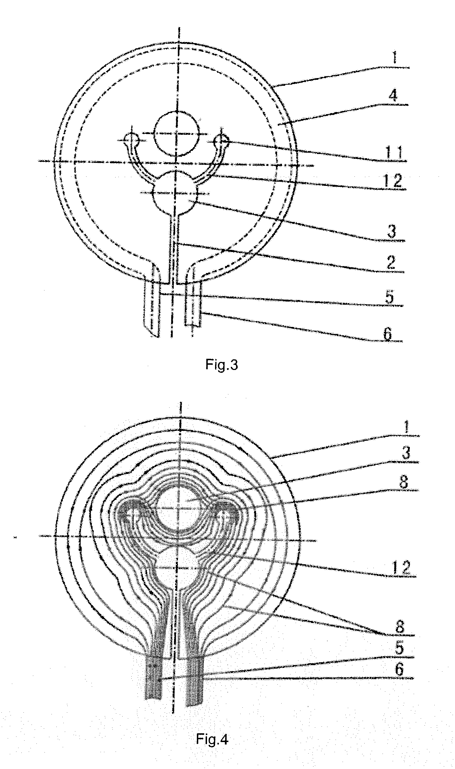

Referring to Fig.3 and Fig.4, in the other embodiment of the invention, the two pulling holes 3 are arranged up and down in parallel, one pulling hole 3 which is communicated with the diffluent troughs 2 is provided with the 'C'-shaped diffluent trough 12 which packs a half of the other pulling hole 3, and the two ends of the 'C'-shaped diffluent trough 12 are provided with the subsidiary electric current guiding holes 11 to form into the other two-pulling holes arrangement; and when working, by running in an encircling way and being guided by the 'C'-shaped diffluent trough 2 and the subsidiary electric current guiding holes which are arranged at the two ends of the 'C'-shaped diffluent trough 2, the electric current 8 evenly flows by respectively encircling the two pulling holes 3.

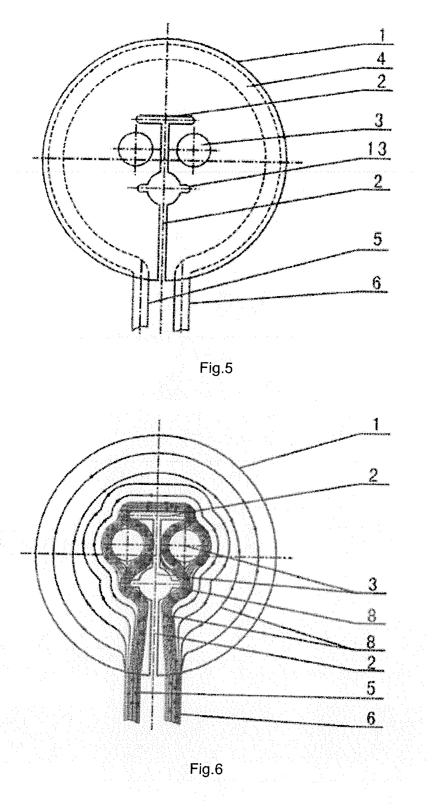

Referring to Fig.5 and Fig.6, the three-pulling holes 3 arrangement in the embodiment of the invention is as follows: the three pulling holes 3 are arranged like a Chinese character ' 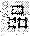 ', wherein one side of one pulling hole 3 is connected with the diffluent troughs 2 between the current transmitting and cooling water transmitting cropper pipeA 5 and the current transmitting and cooling water transmitting cropper pipeB 6, the other side thereof is communicated with the lower end of the 'T'-shaped diffluent trough 2, the two sides of the 'T'-shaped diffluent troughs 2 are respectively provided with the other two pulling holes 3, and the two edges of one pulling hole 3 are respectively provided with a short trough 13 to jointly form into the three-pulling holes arrangement; and when working, by running in an encircling way and being guided by the 'T'-shaped diffluent trough 2, the electric current 8 evenly flows by respectively encircling the three pulling holes 3.

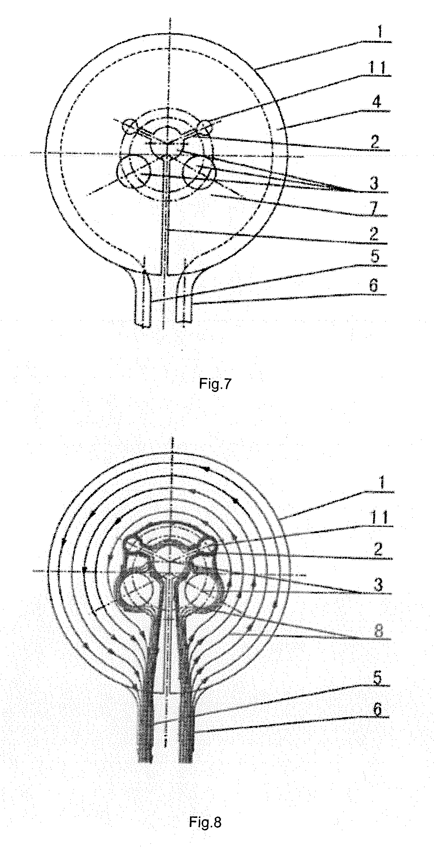

Referring to Fig.7 and Fig.8, the other three-pulling holes 3 an-angement in the other embodiment of the invention is as follows: the diffluent troughs 2 which are arranged between the current transmitting and cooling water transmitting cropper pipeA 5 and the current transmitting and cooling water transmitting cropper pipeB 6 are communicated with the pulling holes 3 which are arranged at the place which is slightly far away from the middle of the high-frequency coil 1, the other two faces of the pulling holes 3 are provided with the diffluent troughs 2, the outer ends of the two diffluent troughs 2 are respectively provided with the subsidiary electric current guiding holes 11, wherein the other two pulling holes 3 are arranged at the two sides of the diffluent troughs 2 to jointly form into the other three-pulling holes arrangement; and when working, by running in an encircling way and being guided by the two diffluent troughs 2 which are arranged at the other two faces of the pulling holes 3 which is slightly far away from the middle part and the subsidiary electric current guiding holes which are arranged at the outer ends of the two diffluent troughs 2, the electric current 8 evenly flows by respectively encircling the two pulling holes 3.

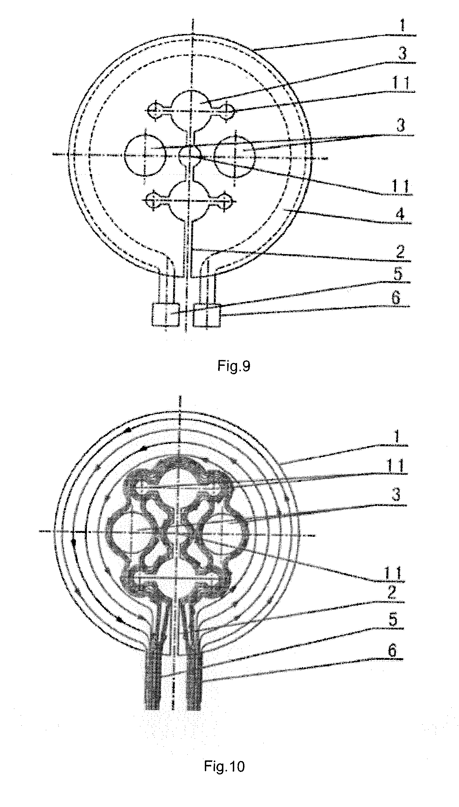

Referring to Fig.9 and Fig.10, the four-pulling holes 3 arrangement in the embodiment of the invention is as follows: the four pulling holes 3 are arranged by means of square, the diffluent troughs 2 between the current transmitting and cooling water transmitting cropper pipeA 5 and the current transmitting and cooling water transmitting cropper pipeB 6 correspond to and are communicated with two of the pulling holes 3 there into, the two sides of the two pulling holes 3 are respectively communicated with the subsidiary electric current guiding holes 11 through the diffluent troughs 2, the middle parts of the communicated diffluent troughs 2 between the two pulling holes 3 are provided with the subsidiary electric current guiding holes 11, and the other two pulling holes 3 are arranged at the two sides of the subsidiary electric current guiding holes 11 to form into four-pulling holes arrangement; and when working, by running in an encircling way and being guided by the diffluent troughs 2 which are arranged at the two sides of the pulling holes corresponding to the diffluent troughs 2 between the current transmitting and cooling water transmitting cropper pipeA 5 and current transmitting and cooling water transmitting cropper pipeB 6 and the subsidiary electric current guiding holes, the electric current 8 evenly flows by respectively encircling the two pulling holes 3.

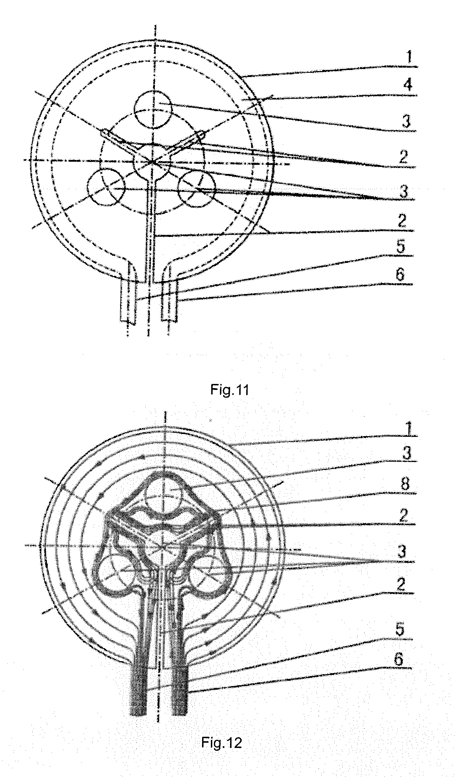

Referring to Fig.11-Fig.20, the five-to-eight-pulling holes arrangement in the embodiment of the invention is as follows: one pulling hole 3 is arranged at the middle, the other four-to-seven pulling holes 3 are evenly enclosed around the middle pulling hole 3, the diffluent troughs 2 between the current transmitting and cooling water transmitting cropper pipeA 5 and the current transmitting and cooling water transmitting cropper pipeB 6 pass through the two of the four-to-seven pulling holes 3 and are communicated with the middle pulling hole 3, the two diffluent troughs 2 are respectively arranged among four-to-seven enclosed pulling holes 3, the diffluent troughs 2 are outwards extended from the middle pulling hole 3 to be positioned among the pulling holes 3, and the outer end of each diffluent trough 2 is positioned between the circular center lines of the three enclosed pulling holes 3 and the peripheral circular lines of the three enclosed pulling holes 3 to form into the five-to-eight-pulling holes arrangement; and it was necessary to state that structures of the five-to-eight-pulling holes arrangements are similar to each other, so that the arrangements are not illustrated one by one.

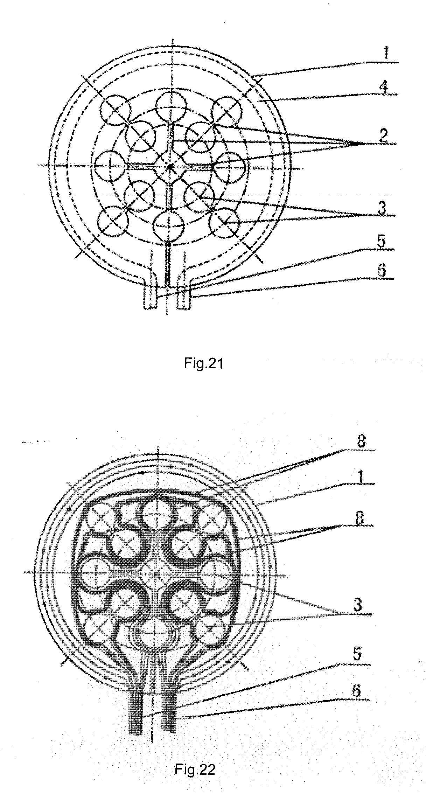

Referring to FIG.21-FIG.22, the thirteen-pulling holes 3 structure in the embodiment of the invention is as follows: the high-frequency coil pulling holes arrangement for producing thirteen silicon cores is that one pulling hole 3 is arranged at the middle part, the other four pulling holes 3 which enclose the middle pulling hole 3 are respectively and equidistantly arranged around the middle pulling hole 3, the diffluent troughs 2 between the current transmitting and cooling water transmitting cropper pipeA 5 and the current transmitting and cooling water transmitting cropper pipeB 6 are communicated with one of the four pulling holes 3 which enclose the middle pulling hole 3, the four enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling holes 3 of the four enclosed pulling holes 3 to form into the thirteen-pulling holes arrangement; and when working, one part of the electric current 8 runs by encircling the outer edge of the thirteen pulling holes 3, and the other part of the electric current 8 shuttles between the barbell-like pulling hole 3 and the middle pulling hole 3, so that the electric current 8 evenly flows by respectively encircling the thirteen pulling holes 3.

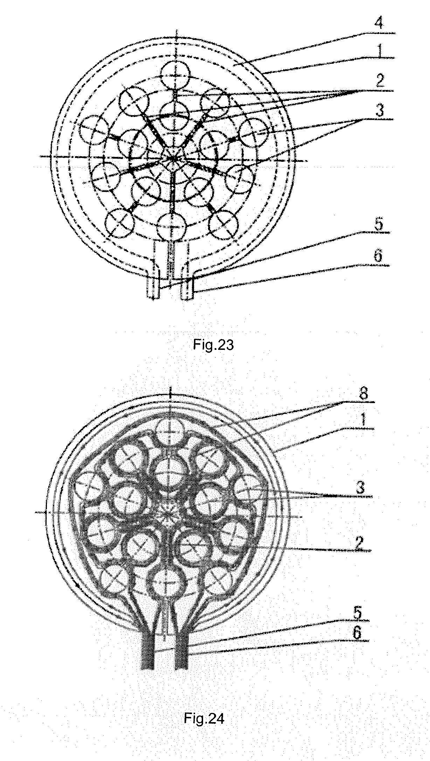

Referring to FIG.23-FIG.24, the sixteen-pulling holes 3 structure in the embodiment of the invention is as follows: the high-frequency coil pulling holes arrangement for producing sixteen silicon cores is that one pulling hole 3 is arranged at the middle part, the other five pulling holes 3 which enclose the middle pulling hole 3 are respectively and equidistantly arranged around the outer part of the middle pulling hole 3, the diffluent troughs 2 between the current transmitting and cooling water transmitting cropper pipeA 5 and the current transmitting and cooling water transmitting cropper pipeB 6 are communicated with one of the five enclosed pulling holes 3, the five enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling holes 3 of the five enclosed pulling holes 3 to form into the sixteen-pulling holes arrangement; and when working, one part of the electric current 8 runs by encircling the outer edge the sixteen pulling holes 3, and the other part of the electric current 8 shuttles between the barbell-like pulling hole 3 and the middle pulling hole 3, so that the electric current 8 evenly flows by respectively encircling the sixteen pulling holes 3.

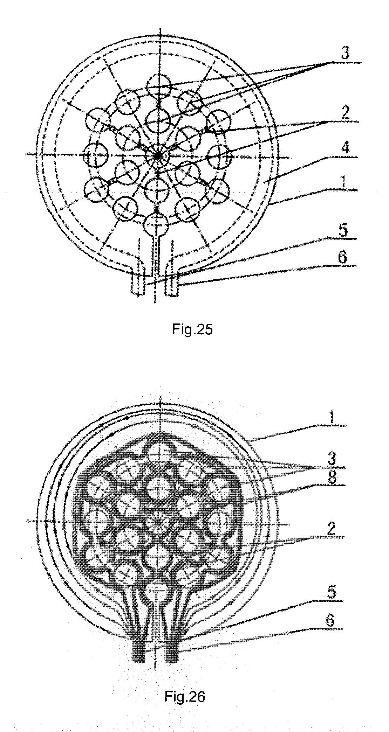

Referring to FIG.25-FIG.26, the nineteen-pulling holes 3 structure in the embodiment of the invention is as follows: the high-frequency coil pulling holes arrangement for producing nineteen silicon cores is that one pulling hole 3 is arranged at the middle part, the other six pulling holes 3 which enclose the middle pulling hole 3 are respectively and equidistantly arranged around the outer part of the middle pulling hole 3, the periphery of the six pulling holes 3 which enclose the middle pulling hole 3 are further provided with six pulling holes 3 corresponding thereto, i.e. the outer edge of the middle pulling hole 3 is enclosed by two layers of the pulling holes 3, the diffluent troughs 2 between the current transmitting and cooling water transmitting cropper pipeA 5 and the current transmitting and cooling water transmitting cropper pipeB 6 are communicated with one of the outermost enclosed six pulling holes 3, the outermost enclosed six pulling holes 3 are respectively passed through the middle other six pulling holes 3 and communicated with the middle pulling hole 3 to form into outward serial structures from the middle part, barbell-like pulling structures which are formed by the two pulling holes 3 and the diffluent troughs 2 communicated therewith are respectively arranged among every two serial structures, and independent pulling holes 3 are respectively arranged between the barbell-like pulling structures and the enclosed peripheral six pulling holes 3 to form into the nineteen-pulling holes arrangement; and when working, one part of the electric current 8 runs by encircling the outer edge of the nineteen pulling holes 3, and the other part of the electric current 8 shuttles among the barbell-like pulling hole 3, the independent pulling hole 3 and the serial pulling hole 3 which is communicated with the middle pulling hole 3, so that the electric current 8 evenly flows by respectively encircling the sixteen pulling holes 3.

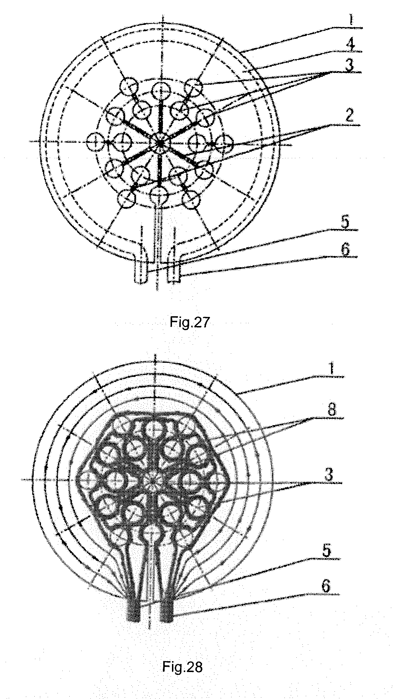

Referring to FIG.27-FIG.28, the other nineteen-pulling holes 3 structure in the embodiment of the invention is as follows: the other extended structure with nineteen silicon cores is that one pulling hole 3 is arranged at the middle part, the other six pulling holes 3 are arranged at the periphery of the middle pulling hole 3, the diffluent troughs 2 are radially communicated with the six pulling holes 3 through the middle pulling hole 3, and barbell-like pulling structures which are formed by the two pulling holes 3 and the diffluent troughs 2 communicated therewith are respectively arranged among every pulling hole 3 to form into the other nineteen-pulling holes arrangement; and when working, one part of the electric current 8 runs by encircling the outer edge of the nineteen pulling holes 3, and the other part of the electric current 8 shuttles between the barbell-like pulling hole 3 and the peripheral six pulling holes 3, so that the electric current 8 evenly flows by respectively encircling the sixteen pulling holes 3.

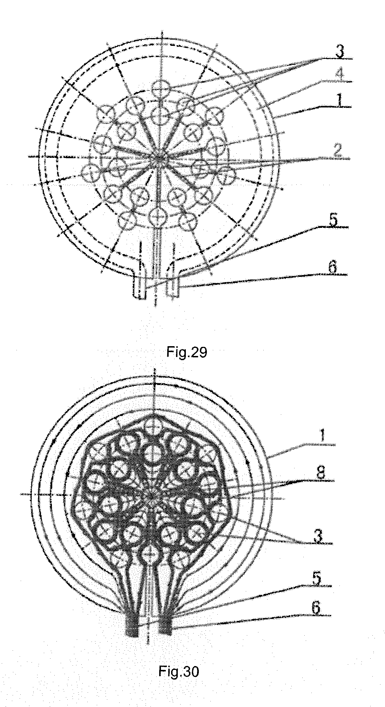

Referring to FIG.29-FIG.30, the twenty two-pulling holes 3 structure in the embodiment of the invention is as follows: the high-frequency coil pulling holes arrangement for producing tenwty two silicon cores is that one pulling hole 3 is arranged at the middle part; the other seven pulling holes 3 which enclose the middle pulling hole 3 are respectively and equidistantly arranged around the outer part of the middle pulling hole 3, the diffluent troughs 2 between the current transmitting and cooling water transmitting cropper pipeA 5 and the current transmitting and cooling water transmitting cropper pipeB 6 are communicated with one of the seven enclosed pulling holes 3, the seven enclosed pulling holes 3 are respectively communicated with the middle pulling hole 3 through the diffluent troughs 2, and barbell-like pulling structures which are formed by the two pulling holes 3 and the diffluent troughs 2 communicated therewith are respectively arranged among every two pulling holes 3 of the seven enclosed pulling holes 3 to form into the tenwty two-pulling holes arrangement; and when working, one part of the electric current 8 runs by encircling the outer edge of the twenty two pulling holes 3, and the other part of the electric current 8 shuttles between the barbell-like pulling hole 3 and the pulling hole 3 which is communicated with the middle pulling hole 3, so that the electric current 8 evenly flows by respectively encircling the twenty two pulling holes 3.

The implementation of the high-frequency coil pulling holes arrangement for producing the multiple silicon cores is as follows:

Referring to the Fig. 31, 32 or 33 and Fig.1-30, the diffluent troughs 2 are arranged between the adjacent current transmitting and cooling water transmitting cropper pipeA 5 and the current transmitting and cooling water transmitting cropper pipeB 6, wherein the connection mode of the diffluent troughs 2 are determined by the actual demand of the Fig.1-30, and the main function of the diffluent troughs 2 is to lead the high-frequency electric current 8 to be mutually used or crossed at the demarcation, so that the raw material stick 16 is evenly heated up and the function of the subsidiary melting materials (raw material stick 16) can be implemented; after melting the part of the end head of the raw material stick 16 (also called as raw material silicon stick), which is near to the lower surface 10 of the high-frequency coil, the clamp head 14 of the seed crystal is lifted down along with the seed crystal 15, so that the seed crystal 15 passes through the pulling holes 3 referring to the FIG.1-30 and is inserted into a melting region of the raw material stick 16, the seed crystal 15 is lifted up, the melted liquid at the upper part of the raw material stick 16 can be lifted up along with the seed crystal 15, the lower shaft at the lower part of the raw material stick 16 is correspondingly, synchronously and slowly lifted up, but the raw material stick 16 can not be contacted with the high-frequency coil 1; as the end part of the raw material stick 16 is possibly to be not flat, the lower surface 10 of the high-frequency coil is designed to be an inward-sunken step, thereby leading raw material stick 16 to be close to the lower part of the high-frequency coil as much as possible and to be fast liquefied, and the upper surface 9 of the high-frequency coil is designed to be an inclination from outside to inside, thereby being capable of preventing the high-frequency electric current 8 from being excessively concentrated at the middle part, so that the high-frequency electric current 8 is evenly spread on the high-frequency coil 3 to implement the effect of even heating; and after being driven by the bonding of the seed crystal 15 to pass through the high-frequency coil 1 and the pulling holes 3, the melting region at the upper part of the raw material stick 1 is condensed due to the reduce of the magnetic force line 17, so that a new columnar crystal is formed, and the clamp head 14 of the seed crystal is slowly lifted up with the seed crystal 15, so that the finished silicon cores with required length can be formed.

It is necessary to state that the clamp head 14 of the seed crystal is only taken as the other auxiliary structure in the implementation process of the invention, so that the invention does not illustrate the clamp head 14 in details, moreover, the clamp head 14 of the seed crystal and the other equipment does not belong to the protection range of the invention.

The embodiments which are selected to disclose the purpose of the invention in the description are currently regarded as to be proper, however, it should be noted that the invention aims at comprising all the changes and improvements of the embodiments which belong to the conception and the range of the invention.

## Claims

1. A high-frequency coil pulling holes arrangement for producing multiple silicon cores, wherein one side of a high-frequency coil (1) is provided with a current transmitting and cooling water transmitting cropper pipeA (5) and a current transmitting and cooling water transmitting cropper pipeB (6), which are adjacent to each other; inward-extended diffluent troughs (2) are arranged between the adjacent current transmitting and cooling water transmitting cropper pipeA (5) and the current transmitting and cooling water transmitting cropper pipeB (6); the upper surface (9) of the high-frequency coil (1) is an inclined plane which is inwards sunken to the center position; the lower surface (10) of the high-frequency coil (1) is provided with a middle sunken circular step; a cooling water channel (4) is buried circularly in the outer edge surface of the high-frequency coil (1); and the two ends of the cooling water channel (4) are respectively communicated with the current transmitting and cooling water transmitting cropper pipeA (5) and the current transmitting and cooling water transmitting cropper pipeB (6), the high-frequency coil pulling holes arrangement is **characterized in that** the diffluent troughs (2) are communicated with pulling holes (3) which are arranged at a concave (7) on the middle of the high-frequency coil (1) or the pulling holes (3) with the shortest straight-line distance or any one of the upper end and lower end of the 'I'-shaped diffluent trough (2) which is arranged at the middle of the high-frequency coil (1) to correspond to the straight-line diffluent trough (2) which is arranged at the middle part of the 'I'-shaped diffluent trough (2);
wherein, subsidiary electric current guiding holes (11) are arranged at the two ends of a 'C'-shaped diffluent trough (12); or the subsidiary electric current guiding holes (11) are arranged at the middle of the diffluent troughs (2); or the subsidiary electric current guiding holes (11) are arranged at the outer ends of the diffluent troughs (2); and
the number of the pulling holes (3) are at least to be 2; the two pulling holes 3 are arranged among 'I'-shaped endpoints corresponding to the two sides of the 'I'-shaped diffluent trough 2 to form into the two-pulling holes arrangement; or the two pulling holes (3) are arranged up and down in parallel, one pulling hole (3) which is communicated with the diffluent troughs (2) is provided with the 'C'-shaped diffluent trough (12) which packs a half of the other pulling hole (3), and the two ends of the `C'-shaped diffluent trough (12) are provided with the subsidiary electric current guiding holes (11) to form into the other two-pulling holes arrangement; or three pulling holes (3) are arranged like a Chinese character ' 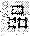 ', wherein one side of one pulling hole (3) is connected with the diffluent troughs (2) between the current transmitting and cooling water transmitting cropper pipeA (5) and the current transmitting and cooling water transmitting cropper pipeB (6), the other side thereof is communicated with the lower end of the 'T'-shaped diffluent trough (2), the two sides of the 'T'-shaped diffluent troughs (2) are respectively provided with the other two pulling holes (3), and the two edges of one pulling hole (3) are respectively provided with a short trough (13) to jointly form into the three-pulling holes arrangement; or the diffluent troughs (2) which are arranged between the current transmitting and cooling water transmitting cropper pipeA (5) and the current transmitting and cooling water transmitting cropper pipeB (6) are communicated with the pulling holes (3) which are arranged at the place which is slightly far away from the middle of the high-frequency coil (1), the other two faces of the pulling holes (3) are provided with the diffluent troughs (2), the outer ends of the two diffluent troughs (2) are respectively provided with the subsidiary electric current guiding holes (11), wherein the other two pulling holes (3) are arranged at the two sides of the diffluent troughs (2) to jointly form into the other three-pulling holes arrangement; or the four pulling holes (3) are arranged by means of square, the diffluent troughs (2) between the current transmitting and cooling water transmitting cropper pipeA (5) and the current transmitting and cooling water transmitting cropper pipeB (6) correspond to and are communicated with two of the pulling holes (3) thereinto, the two sides of the two pulling holes (3) are respectively communicated with the subsidiary electric current guiding holes (11) through the diffluent troughs (2), the middle parts of the communicated diffluent troughs (2) between the two pulling holes (3) are provided with the subsidiary electric current guiding holes (11), and the other two pulling holes (3) are arranged at the two sides of the subsidiary electric current guiding holes (11) to form into four-pulling holes arrangement; or the four pulling holes (3) have the following arrangement: one pulling hole (3) is arranged at the middle, the other three pulling holes (3) are evenly enclosed around the middle pulling hole (3), the diffluent troughs (2) between the current transmitting and cooling water transmitting cropper pipeA (5) and the current transmitting and cooling water transmitting cropper pipeB (6) pass through the two of the three pulling holes (3) and are communicated with the middle pulling hole (3), the other two diffluent troughs (2) are outwards extended from the middle pulling hole (3) to be positioned between the two pulling holes (3) of the three enclosed pulling holes (3), and the outer ends of the two diffluent troughs (2) are positioned between the circular center lines of the three enclosed pulling holes (3) and the peripheral circular lines of the three enclosed pulling holes (3) to form into the other four-pulling holes arrangement; or one pulling hole (3) is arranged at the middle part, the other pulling holes (3) encloses around the middle pulling hole (3), the diffluent troughs (2) between the current transmitting and cooling water transmitting cropper pipeA (5) and the current transmitting and cooling water transmitting cropper pipeB (6) are communicated with the middle pulling hole (3), the diffluent troughs (2) are respectively arranged among the peripherally-enclosed pulling holes (3), or the middle pulling hole (3) is directly communicated with the peripheral pulling holes (3) through the diffluent troughs (2).

2. The high-frequency coil pulling holes arrangement for producing multiple silicon cores of claim 1, wherein the high-frequency coil pulling holes arrangement for producing five silicon cores is **characterized in that** one pulling hole (3) is arranged at the middle part, the other four pulling holes (3) are evenly enclosed around the middle pulling hole (3), the diffluent troughs (2) between the current transmitting and cooling water transmitting cropper pipeA (5) and the current transmitting and cooling water transmitting cropper pipeB (6) pass through the two of the four pulling holes (3) and are communicated with the middle pulling hole (3), the other three diffluent troughs (2) are outwards extended from the middle pulling hole (3) to be positioned among the three pulling holes (3) of the four enclosed pulling holes (3), and the outer ends of the three diffluent troughs (2) are positioned between the circular center lines of the four enclosed pulling holes (3) and the peripheral circular lines of the four enclosed pulling holes (3) to form into the five-pulling holes arrangement.

3. The high-frequency coil pulling holes arrangement for producing multiple silicon cores of claim 1, wherein the high-frequency coil pulling holes arrangement for producing six silicon cores is **characterized in that** one pulling hole (3) is arranged at the middle part, the other five pulling holes (3) are evenly enclosed around the middle pulling hole (3), the diffluent troughs (2) between the current transmitting and cooling water transmitting cropper pipeA (5) and the current transmitting and cooling water transmitting cropper pipeB (6) pass through the two of the five pulling holes (3) and are communicated with the middle pulling hole (3), the other four diffluent troughs (2) are outwards extended from the middle pulling hole (3) to be positioned among the four pulling holes (3) of the five enclosed pulling holes (3), and the outer ends of the fiour diffluent troughs (2) are positioned between the circular center lines of the five enclosed pulling holes (3) and the peripheral circular lines of the five enclosed pulling holes (3) to form into the six-pulling holes arrangement.

4. The high-frequency coil pulling holes arrangement for producing multiple silicon cores of claim 1, wherein the high-frequency coil pulling holes arrangement for producing seven silicon cores is **characterized in that** one pulling hole (3) is arranged at the middle part, the other six pulling holes (3) are evenly enclosed around the middle pulling hole (3), the diffluent troughs (2) between the current transmitting and cooling water transmitting cropper pipeA (5) and the current transmitting and cooling water transmitting cropper pipeB (6) pass through the two of the six pulling holes (3) and are communicated with the middle pulling hole (3), the other five diffluent troughs (2) are outwards extended from the middle pulling hole (3) to be positioned among the five pulling holes (3) of the six enclosed pulling holes (3), and the outer ends of the five diffluent troughs (2) are positioned between the circular center lines of the six enclosed pulling holes (3) and the peripheral circular lines of the six enclosed pulling holes (3) to form into the seven-pulling holes arrangement.

5. The high-frequency coil pulling holes arrangement for producing multiple silicon cores of claim 1, wherein the high-frequency coil pulling holes arrangement for producing eight silicon cores is **characterized in that** one pulling hole (3) is arranged at the middle part, the other seven pulling holes (3) are evenly enclosed around the middle pulling hole (3), the diffluent troughs (2) between the current transmitting and cooling water transmitting cropper pipeA (5) and the current transmitting and cooling water transmitting cropper pipeB (6) pass through the two of the seven pulling holes (3) and are communicated with the middle pulling hole (3), the other six diffluent troughs (2) are outwards extended from the middle pulling hole (3) to be positioned among the six pulling holes (3) of the seven enclosed pulling holes (3), and the outer ends of the six diffluent troughs (2) are positioned between the circular center lines of the seven enclosed pulling holes (3) and the peripheral circular lines of the seven enclosed pulling holes (3) to form into the eight-pulling holes arrangement.

6. The high-frequency coil pulling holes arrangement for producing multiple silicon cores of claim 1, wherein the pulling holes arrangement has an extended structure, i.e. the two pulling holes (3) and the diffluent troughs (2) connected therewith are formed into barbell-like pulling holes (3), and the barbell-like pulling holes (3) are respectively arranged between the middle pulling hole (3) and the peripheral pulling holes (3) to form into thirteen, sixteen, nineteen and twenty two high-frequency coil pulling holes arrangement, the high-frequency coil pulling holes arrangement for producing thirteen silicon cores is **characterized in that** one pulling hole (3) is arranged at the middle part, the other four pulling holes (3) which enclose the middle pulling hole (3) are respectively and equidistantly arranged around the middle pulling hole (3), the diffluent troughs (2) between the current transmitting and cooling water transmitting cropper pipeA (5) and the current transmitting and cooling water transmitting cropper pipeB (6) are communicated with one of the four pulling holes, (3) which enclose the middle pulling hole (3), the four enclosed pulling holes (3) are respectively communicated with the middle pulling hole (3) through the diffluent troughs (2), and barbell-like pulling structures which are formed by the two pulling holes (3) and the diffluent troughs (2) communicated therewith are respectively arranged among every two pulling holes (3) of the four enclosed pulling holes (3) to form into the thirteen-pulling holes arrangement.

7. The high-frequency coil pulling holes arrangement for producing multiple silicon cores of claim 1 or 6, wherein the high-frequency coil pulling holes arrangement for producing sixteen silicon cores is **characterized in that** one pulling hole (3) is arranged at the middle part, the other five pulling holes (3) which enclose the middle pulling hole (3) are respectively and equidistantly arranged around the outer part of the middle pulling hole (3), the diffluent troughs (2) between the current transmitting and cooling water transmitting cropper pipeA (5) and the current transmitting and cooling water transmitting cropper pipeB (6) are communicated with one of the five enclosed pulling holes (3), the five enclosed pulling holes (3) are respectively communicated with the middle pulling hole (3) through the diffluent troughs (2), and barbell-like pulling structures which are formed by the two pulling holes (3) and the diffluent troughs (2) communicated therewith are respectively arranged among every two pulling holes (3) of the five enclosed pulling holes (3) to form into the sixteen-pulling holes arrangement.

8. The high-frequency coil pulling holes arrangement for producing multiple silicon cores of claim 1 or 6, wherein the high-frequency coil pulling holes arrangement for producing nineteen silicon cores is **characterized in that** one pulling hole (3) is arranged at the middle part, the other six pulling holes (3) which enclose the middle pulling hole (3) are respectively and equidistantly arranged around the outer part of the middle pulling hole (3), the periphery of the six pulling holes (3) which enclose the middle pulling hole (3) are further provided with six pulling holes (3) corresponding thereto, i.e. the outer edge of the middle pulling hole (3) is enclosed by two layers of the pulling holes (3), the diffluent troughs (2) between the current transmitting and cooling water transmitting cropper pipeA (5) and the current transmitting and cooling water transmitting cropper pipeB (6) are communicated with one of the outermost enclosed six pulling holes (3), the outermost enclosed six pulling holes (3) are respectively passed through the middle other six pulling holes (3) and communicated with the middle pulling hole (3) by the diffluent troughs (2) to form into outward serial structures from the middle part, barbell-like pulling structures which are formed by the two pulling holes (3) and the diffluent troughs (2) communicated therewith are respectively arranged among every two serial structures, and independent pulling holes (3) are respectively arranged between the barbell-like pulling structures and the enclosed peripheral six pulling holes (3) to form into the nineteen-pulling holes arrangement.

9. The high-frequency coil pulling holes arrangement for producing multiple silicon cores of claim 1 or 6, wherein the high-frequency coil pulling holes arrangement for producing tenwty two silicon cores is **characterized in that** one pulling hole (3) is arranged at the middle part, the other seven pulling holes (3) which enclose the middle pulling hole (3) are respectively and equidistantly arranged around the outer part of the middle pulling hole (3), the diffluent troughs (2) between the current transmitting and cooling water transmitting cropper pipeA (5) and the current transmitting and cooling water transmitting cropper pipeB (6) are communicated with one of the seven enclosed pulling holes (3), the seven enclosed pulling holes (3) are respectively communicated with the middle pulling hole (3) through the diffluent troughs (2), and barbell-like pulling structures which are formed by the two pulling holes (3) and the diffluent troughs (2) communicated therewith are respectively arranged among every two pulling holes (3) of the seven enclosed pulling holes (3) to form into the tenwty two-pulling holes arrangement.

10. The high-frequency coil pulling holes arrangement for producing multiple silicon cores of claim 1, wherein the other extended structure for producing nineteen silicon cores is **characterized in that** one pulling hole (3) is arranged at the middle part, the other six pulling holes (3) are arranged at the periphery of the middle pulling hole (3), the diffluent troughs (2) are radially communicated with the six pulling holes (3) through the middle pulling hole (3), and barbell-like pulling structures which are formed by the two pulling holes (3) and the diffluent troughs (2) communicated therewith are respectively arranged among every pulling hole (3) to form into the other nineteen-pulling holes arrangement.

## Amended claims

### Amended claims under Art. 19.1 PCT

**1.** A high-frequency coil pulling holes arrangement for producing multiple silicon cores, wherein one side of a high-frequency coil (1) is provided with a current transmitting and cooling water transmitting cropper pipeA (5) and a current transmitting and cooling water transmitting cropper pipeB (6), which are adjacent to each other; inward-extended diffluent troughs (2) are arranged between the adjacent current transmitting and cooling water transmitting cropper pipeA (5) and the current transmitting and cooling water transmitting cropper pipeB (6); the upper surface (9) of the high-frequency coil (1) is an inclined plane which is inwards sunken to the center position; the lower surface (10) of the high-frequency coil (1) is provided with a middle sunken circular step; a cooling water channel (4) is buried circularly in the outer edge surface of the high-frequency coil (1); and the two ends of the cooling water channel (4) are respectively communicated with the current transmitting and cooling water transmitting cropper pipeA (5) and the current transmitting and cooling water transmitting cropper pipeB (6), it is **characterized in that** the diffluent troughs (2) are communicated with pulling holes (3) which are arranged at a concave (7) on the middle of the high-frequency coil (1) or the pulling holes (3) with the shortest straight-line distance or any one of the upper end and lower end of the 'I'-shape diffluent trough (2) which is arranged at the middle of the high-frequency coil (1) to correspond to the straight-line diffluent trough (2) which is arranged at the middle part of the `I'-shaped diffluent trough (2);
wherein, subsidiary electric current guiding holes (11) are arranged at the two ends of a 'C'-shaped diffluent trough (12); or the subsidiary electric current guiding holes (11) are arranged at the middle of the diffluent troughs (2); or the subsidiary electric current guiding holes (11) are arranged at the outer ends of the diffluent troughs (2); and
the number of the pulling holes (3) are at least to be 2; the two pulling holes (3) are arranged among `I'-shaped endpoints corresponding to the two sides of the 'I'-shape diffluent trough (2) to form into the two-pulling holes arrangement; or the two pulling holes (3) are arranged up and down in parallel, one pulling hole (3) which is communicated with the diffluent troughs (2) is provided with the 'C'-shaped diffluent trough (12) which packs a half of the other pulling hole (3), and the two ends of the 'C'-shaped diffluent trough (12) are provided with the subsidiary electric current guiding holes (11) to form into the other two-pulling holes arrangement; or three pulling holes (3) are arranged like a Chinese character ' 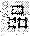 ', wherein one side of one pulling hole (3) is connected with the diffluent troughs (2) between the current transmitting and cooling water transmitting cropper pipeA (5) and the current transmitting and cooling water transmitting cropper pipeB (6), the other side thereof is communicated with the lower end of the `T'-shaped diffluent trough (2), the two sides of the `T'-shaped diffluent troughs (2) are respectively provided with the other two pulling holes (3), and the two edges of one pulling hole (3) are respectively provided with a short trough (13) to jointly form into the three-pulling holes arrangement; or the diffluent troughs (2) which are arranged between the current transmitting and cooling water transmitting cropper pipeA (5) and the current transmitting and cooling water transmitting cropper pipeB (6) are communicated with the pulling holes (3) which are arranged at the place which is slightly far away from the middle of the high-frequency coil (1), the other two faces of the pulling holes (3) are provided with the diffluent troughs (2), the outer ends of the two diffluent troughs (2) are respectively provided with the subsidiary electric current guiding holes (11), wherein the other two pulling holes (3) are arranged at the two sides of the diffluent troughs (2) to jointly form into the other three-pulling holes arrangement ; or the four pulling holes (3) are arranged by means of square, the diffluent troughs (2) between the current transmitting and cooling water transmitting cropper pipeA (5) and the current transmitting and cooling water transmitting cropper pipeB (6) correspond to and are communicated with two of the pulling holes (3) thereinto, the two sides of the two pulling holes (3) are respectively communicated with the subsidiary electric current guiding holes (11) through the diffluent troughs (2), the middle parts of the communicated diffluent troughs (2) between the two pulling holes (3) are provided with the subsidiary electric current guiding holes (11), and the other two pulling holes (3) are arranged at the two sides of the subsidiary electric current guiding holes (11) to form into four-pulling holes arrangement.

**2.** The high-frequency coil pulling holes arrangement for producing multiple silicon cores of claim 1, wherein the pulling holes arrangement has an extended structure, i.e. the two pulling holes (3) and the diffluent troughs (2) connected therewith are formed into barbell-like pulling holes (3), and the barbell-like pulling holes (3) are respectively arranged between the middle pulling hole (3) and the peripheral pulling holes (3) to form into thirteen, sixteen, nineteen and twenty two high-frequency coil pulling holes arrangement, the high-frequency coil pulling holes arrangement for producing thirteen silicon cores is **characterized in that** one pulling hole (3) is arranged at the middle part, the other four pulling holes (3) which enclose the middle pulling hole (3) are respectively and equidistantly arranged around the middle pulling hole (3), the diffluent troughs (2) between the current transmitting and cooling water transmitting cropper pipeA (5) and the current transmitting and cooling water transmitting cropper pipeB (6) are communicated with one of the four pulling holes (3) which enclose the middle pulling hole (3), the four enclosed pulling holes (3) are respectively communicated with the middle pulling hole (3) through the diffluent troughs (2), and barbell-like pulling structures which are formed by the two pulling holes (3) and the diffluent troughs (2) communicated therewith are respectively arranged among every two pulling holes (3) of the four enclosed pulling holes (3) to form into the thirteen-pulling holes arrangement.

**3.** The high-frequency coil pulling holes arrangement for producing multiple silicon cores of claim 1 or 2, wherein the high-frequency coil pulling holes arrangement for producing sixteen silicon cores is **characterized in that** one pulling hole (3) is arranged at the middle part, the other five pulling holes (3) which enclose the middle pulling hole (3) are respectively and equidistantly arranged around the outer part of the middle pulling hole (3), the diffluent troughs (2) between the current transmitting and cooling water transmitting cropper pipeA (5) and the current transmitting and cooling water transmitting cropper pipeB (6) are communicated with one of the enclosed five pulling holes (3), the five enclosed pulling holes (3) are respectively communicated with the middle pulling hole (3) through the diffluent troughs (2),
and barbell-like pulling structures which are formed by the two pulling holes (3) and the diffluent troughs (2) communicated therewith are respectively arranged among every two pulling holes (3) of the five enclosed pulling holes (3) to form into the sixteen-pulling holes arrangement.

**4.** The high-frequency coil pulling holes arrangement for producing multiple silicon cores of claim 1 or 2, wherein the high-frequency coil pulling holes arrangement for producing nineteen silicon cores is **characterized in that** one pulling hole (3) is arranged at the middle part, the other six pulling holes (3) which enclose the middle pulling hole (3) are respectively and equidistantly arranged around the outer part of the middle pulling hole (3), the periphery of the six pulling holes (3) which enclose the middle pulling hole (3) are further provided with six pulling holes (3) corresponding thereto, i.e. the outer edge of the middle pulling hole (3) is enclosed by two layers of the pulling holes (3), the diffluent troughs (2) between the current transmitting and cooling water transmitting cropper pipeA (5) and the current transmitting and cooling water transmitting cropper pipeB (6) are communicated with one of the outermost enclosed six pulling holes (3), the outermost enclosed six pulling holes (3) are respectively passed through the middle other six pulling holes (3) and communicated with the middle pulling hole (3) by the diffluent troughs (2) to form into outward serial structures from the middle part, barbell-like pulling structures which are formed by the two pulling holes (3) and the diffluent troughs (2) communicated therewith are respectively arranged among every two serial structures, and independent pulling holes (3) are respectively arranged between the barbell-like pulling structures and the enclosed peripheral six pulling holes (3) to form into the nineteen-pulling holes arrangement.

**5.** The high-frequency coil pulling holes arrangement for producing multiple silicon cores of claim 1 or 2, wherein the high-frequency coil pulling holes arrangement for producing tenwty two silicon cores is **characterized in that** one pulling hole (3) is arranged at the middle part, the other seven pulling holes (3) which enclose the middle pulling hole (3) are respectively and equidistantly arranged around the outer part of the middle pulling hole (3), the diffluent troughs (2) between the current transmitting and cooling water transmitting cropper pipeA (5) and the current transmitting and cooling water transmitting cropper pipeB (6) are communicated with one of the seven enclosed pulling holes (3), the seven enclosed pulling holes (3) are respectively communicated with the middle pulling hole (3) through the diffluent troughs (2), and barbell-like pulling structures which are formed by the two pulling holes (3) and the diffluent troughs (2) communicated therewith are respectively arranged among every two pulling holes (3) of the seven enclosed pulling holes (3) to form into the tenwty two-pulling holes arrangement.

**6.** The high-frequency coil pulling holes arrangement for producing multiple silicon cores of claim 1, wherein the other extended structure for producing nineteen silicon cores is **characterized in that** one pulling hole (3) is arranged at the middle part, the other six pulling holes (3) are arranged at the periphery of the middle pulling hole (3), the diffluent troughs (2) are radially communicated with the six pulling holes (3) through the middle pulling hole (3), and barbell-like pulling structures which are formed by the two pulling holes (3) and the diffluent troughs (2) communicated therewith are respectively arranged among every pulling hole (3) to form into the other nineteen-pulling holes arrangement.
